# EUROPÄISCHE PATENTSCHRIFT

(11) **EP 0 380 946 B1**
(45) Veröffentlichungstag und Bekanntmachung des Hinweises auf die Patenterteilung: **14.09.1994**
(21) Anmeldenummer: 90100645.2
(22) Anmeldetag: 12.01.1990
(51) Int. Cl.: H03L 7/095, H04L 7/033

(54) **Verfahren zur Überwachung der Regelfähigkeit eines Phasenregelkreises**
Method for the control of the regulation ability of a phase-locked loop circuit
Procédé de surveillance de la possibilité de réglage d'une boucle d'asservissement de phase

(30) Priorität: 31.01.1989 DE 3902831
(43) Veröffentlichungstag der Anmeldung: 08.08.1990
(73) Patentinhaber: SIEMENS AKTIENGESELLSCHAFT, 80333 München (DE)
(72) Erfinder: Ernst, Wolfram, Dipl.-Ing., D-8000 München 70 (DE)

(56) Entgegenhaltungen:
- EP-A- 0 278 079
- US-A- 4 499 434

## Beschreibung

Die Erfindung betrifft ein Verfahren zur Überwachung der Regelfähigkeit eines Phasenregelkreises, insbesondere eines Phasenregelkreises in einem zentralen Taktgenerator einer Fernmeldevermittlungsstelle nach dem Oberbegriff des Anspruchs 1.

Zentrale Taktgeneratoren für die Synchronisierung digitaler Vermittlungsstellen (z.B. EWSD) beinhalten Phasenregelkreise bestehend aus Phasendiskriminator zum Vergleich der Phasenlage zwischen Eingangs- und Ausgangsfrequenz, Regler, spannungsgesteuerten Oszillator und Rückführung der Ausgangsfrequenz.

Im normalen Regelbetrieb kann eine Phasendifferenz PD am Phasendiskriminator einen durch den zulässigen Jitter/Wander der Referenzfrequenz und die Regelzeitkonstanten bestimmten Maximalwert nicht überschreiten. Bei Defekten im Phasenregelkreis nimmt die Phasendifferenz bedingt durch die Alterungsdrift des spannungsgesteuerten Oszillators stetig zu. Deshalb wird die Regelfähigkeit des Phasenregelkreises dadurch überwacht, daß das Überschreiten der Phasendifferenz über einen durch eine Alarmschwelle AS definierten Wert einen Synchronalarm auslöst.

Frequenzsprünge bzw. schnelle Frequenzänderungen am Eingang des Phasenregelkreises, die den frequenzmäßigen Aussteuerungsbereich des spannungsgesteuerten Oszillators voll ausschöpfen, führen zu Phasendifferenzen, die den Arbeitsbereich des Phasendiskriminators voll ausschöpfen und beispielsweise bei einem PI-Regler erst nach Vielfachen der Integrationszeitkonstanten wieder abgebaut werden.

Diese Frequenzsprünge dürfen bei einem intakten Phasenregelkreis nicht zu einem Synchronalarm führen.

Es ist deshalb bekannt, die genannte Alarmschwelle AS für Synchronalarm ganz an den Rand des Arbeitsbereiches, d.h. bis an die Übersteuerungsgrenze des Phasendiskriminators zu legen.

Des weiteren ist es bekannt, einen spannungsgesteuerten Oszillator einzusetzen, dessen Aussteuerungsbereich wesentlich größer ist, als die geforderten zulässigen Frequenzsprünge, so daß der Arbeitsbereich des Phasendiskriminators durch diese nicht voll ausgereizt wird. Die Alarmschwelle braucht dann nicht mehr ganz an den Rand des Arbeitsbereiches des Phasendiskriminators gelegt zu werden, ohne daß Frequenzsprünge dadurch fälschlicherweise einen Synchronalarm auslösen würden.

Die beiden genannten Varianten haben den Nachteil, daß die Überwachungszeitdauer zur Bewertung der Regelfähigkeit des Phasenregelkreises um so größer wird, je größere Frequenzsprünge zugelassen werden. Bei der zweiten Variante muß zudem der Aussteuerungsbereich des spannungsgesteuerten Oszillators wesentlich größer sein, als die maximal zulässigen Frequenzsprünge.

Der Erfindung liegt die Aufgabe zugrunde, die Regelfähigkeit des Phasenregelkreises trotz großer zulässiger Frequenzsprünge am Eingang des Phasendiskriminators in kurzer Zeit zu bewerten.

Diese Aufgabe wird bei einem gattungsgemäßen verfahren durch die kennzeichnenden Merkmale des Anspruchs 1 gelöst.

Da ein Überschreiten des durch die Alarmschwelle AS festgelegten Wertes der Phasendifferenz PD, das durch Frequenzsprünge hervorgerufen wird, wegen der erfindungsgemäßen Maßnahmen somit nicht mehr fälschlicherweise zum Synchronalarm führt, kann die Alarmschwelle sehr niedrig gelegt werden. Dies hat zur Folge, daß die Regelfähigkeit des Phasenregelkreises trotz großer zulässiger Frequenzsprünge in kurzer Zeit bewertet werden kann.

Außerdem können durch diese Maßnahme Frequenzsprünge bis zur Aussteuerungsgrenze zugelassen werden, ohne daß dadurch die Zeitdauer der Bewertung der Regelfähigkeit im wesentlichen beeinflußt wird.

Durch die weitere Ausgestaltung der Erfindung nach Anspruch 2 wird in besonders einfacher Weise, nämlich durch Phasenkorrektur verhindert, daß fälschlicherweise ein Synchronalarm ausgelöst wird.

Es folgt die Erläuterung eines speziellen Ausführungsbeispiels der Erfindung anhand einer Figur.

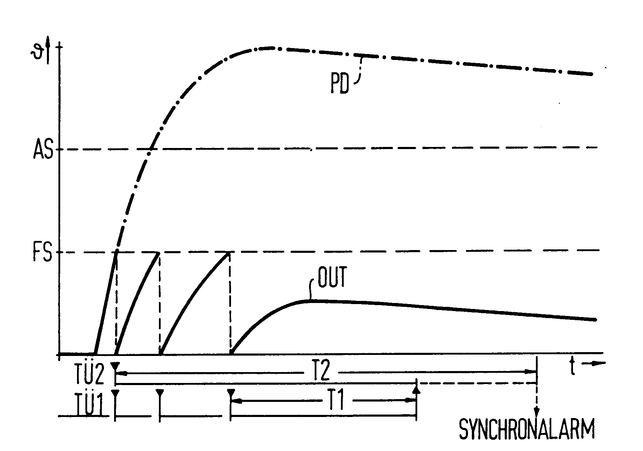

Die Figur zeigt den zeitlichen Verlauf der Phasendifferenz PD zwischen Eingangs- und Ausgangsfrequenz des Phasenregelkreises, sowie den Verlauf eines Ausgangssignals OUT des Phasendiskriminators bei einem speziellen Ausführungsbeispiel der Erfindung, das sich nach Anspruch 2 orientiert.

Dabei würde das Überschreiten der Alarmschwelle AS durch das Ausgangssignal OUT des Phasendiskriminators einen Synchronalarm auslösen. Wie und unter welchen Umständen das verhindert wird, wird nun näher erklärt.

Zunächst ist noch zu bemerken, daß die Überwachung des Gradienten der Phasendifferenz PD zur Erkennung von Frequenzsprüngen grundsätzlich unabhängig von der absoluten Phasendifferenz zwischen Eingangs- und Ausgangsfrequenz durchgeführt wird, d.h. es wird nur die Änderung der Phasendifferenz in einer bestimmten Zeit überwacht. In dem anhand der Figur betrachteten Ausführungsbeispiel geschieht dies dadurch, daß ein erstes Zeitglied TÜ1 mit einer ersten Zeitspanne T1 in Verbindung mit einer relativen Schwelle FS eine Gradientenschwelle festlegt. Das Überschreiten der relativen Schwelle FS vor dem Ablauf des ersten Zeitgliedes TÜ1 bedeutet dabei ein Überschreiten der Gradientenschwelle, während ein Unterschreiten der Gradientenschwelle vorliegt, wenn das das erste Zeitglied abläuft, ohne daß die relative Schwelle FS überschritten wurde. Die relative Schwelle FS muß betragsmäßig kleiner als die Alarmschwelle AS sein.

Bei einem durch einen Frequenzsprung hervorgerufenen erstmaligen Überschreiten der Gradientenschwelle, wird ein zweites Zeitglied TÜ2 gestartet und eine Phasenkorrektur durchgeführt, durch die die Phasendifferenz am Eingang des Phasendiskriminators und damit das Ausgangssignal OUT des Phasendiskriminators zu Null gemacht wird. Das zweite Zeitglied TÜ2 definiert dabei eine zweite Zeitspanne T2,innerhalb deren erkennbar wird, ob der Phasenregelkreis ordnungsgemäß arbeitet (im Falle eines erneuten Unterschreitens der Gradientenschwelle), oder nicht (im Falle eines andauernden Überschreitens der Gradientenschwelle über die gesamte Zeitspanne T2). Dabei wird während der Zeitspanne T2 auch bei Überschreiten der Alarmschwelle verhindert, daß vorzeitig ein Synchronalarm ausgelöst wird. Die genannte Phasenkorrektur wird mittels eines Zählers erreicht, über den die Ausgangsfrequenz auf den Eingang des Phasendiskriminators zurückgeführt wird.

Bei jedem Überschreiten der Gradientenschwelle wird eine Phasenkorrektur durchgeführt und das erste Zeitglied erneut gestartet, d.h. es wird erneut auf Überschreiten der Gradientenschwelle überwacht.

Dadurch wird verhindert, daß das Ausgangssignal OUT des Phasendiskriminators wegen eines Frequenzsprunges die Alarmschwelle überschreitet und somit Synchronalarm auslöst, obwohl der Phasenregelkreis möglicherweise ordnungsgemäß arbeitet. Mit anderen Worten bedeutet dies, daß die Alarmschwelle nun unabhängig von der Größe der zulässigen Frequenzsprünge sehr niedrig gelegt werden kann.

Der vor jeder Phasenkorrektur aufgelaufene Wert des Ausgangssignals OUT des Phasendiskriminators, der der relativen Schwelle FS entspricht, wird gespeichert, damit der Regler diesen Wert bei der Bildung der Stellwerte für den weiteren Regelprozeß mitberücksichtigen kann und sich so am Regelprozeß trotz der Phasenkorrekturen nichts ändert. Bei einem PI-Regler kann der aufgelaufene Wert im Integrationsregister gespeichert werden.

Durch die durch einen Frequenzsprung veranlaßte zeitliche Änderung der Phasendifferenz PD kann die Gradientenschwelle mehrmals überschritten werden, bis die Ausgangsfrequenz durch den Regelprozeß soweit nachgeführt ist, daß die Gradientenschwelle nicht mehr überschritten wird. Diese Nachführung der Ausgangsfrequenz muß bei einem intakten Phasenregelkreis in einer bestimmten Zeit, die von den Zeitkonstanten des Phasenregelkreises abhängt (im wesentlichen von der Proportional-Zeitkonstanten) erfolgt sein. Die zweite Zeitspanne T2 ist somit einerseits größer zu wählen als diese Zeit, kann jedoch andererseits erheblich kleiner gewählt werden, als diejenige Zeit, die zum Ausregeln der durch den Frequenzsprung entstandenen Phasendifferenz PD benötigt wird.

Erfolgt ständiges Überschreiten der Gradientenschwelle über die gesamte zweite Zeitspanne T2 hinweg, so liegt ein Defekt im Phasenregelkreis vor, wie z.B. eine Unterbrechung zwischen Regler und spannungsgesteuertem Oszillator. Der Ablauf des zweiten Zeitgliedes TÜ2 bewirkt deshalb einen Synchronalarm.

Läuft das erste Zeitglied TÜ1 jedoch vor Ablauf des zweiten Zeitgliedes TÜ2 ab, d.h. wird die Gradientenschwelle also vor Ablauf des zweiten Zeitgliedes nicht mehr überschritten, so arbeitet der Phasenregelkreis ordnungsgemäß und ein Synchronalarm muß verhindert werden. Deshalb löscht der Ablauf des ersten Zeitgliedes das zweite Zeitglied. Außerdem muß das erste Zeitglied so bemessen sein, daß das Ausgangssignal OUT des Phasendiskriminators bei einem Unterschreiten der Gradientenschwelle auch die Alarmschwelle AS mit Sicherheit nicht mehr überschreiten kann. Sonst könnte es passieren, daß fälschlicherweise ein Synchronalarm ausgelöst wird, obwohl der Phasenregelkreis ordnungsgemäß arbeitet.

Bei einem Defekt im Phasenregelkreis (z.B. Unterbrechung der Verbindung zwischen Regler und Phasendiskriminator), der (aufgrund der Alterung des spannungsgesteuerten Oszillators) eine langsame Phasendrift der Ausgangsfrequenz und damit eine langsame Drift der Phasendifferenz zur Folge hat, wird die Gradientenschwelle nie überschritten und deshalb auch keine Phasenkorrektur durchgeführt. Das Ausgangssignal OUT des Phasendiskriminators wird daher die niedrig liegende Alarmschwelle in kurzer Zeit überschreiten und wie erwünscht Synchronalarm auslösen.

Bei dem geschilderten speziellen Ausführungsbeispiel wird also unter bestimmten Bedingungen das Überschreiten der Alarmschwelle AS (und damit das Auslösen einen Synchronalarms) durch Phasenkorrektur verhindert. Es wäre jedoch ebenso denkbar, daß nicht etwa das Überschreiten selbst verhindert wird, sondern daß das Auslösen des Synchronalarms z.B. durch ein Sperrsignal verhindert wird.

## Patentansprüche

1. Verfahren zur Überwachung der Regelfähigkeit eines Phasenregelkreises, insbesondere eines Phasenregelkreises in einem zentralen Taktgenerator einer Fernmeldevermittlungsstelle, bei dem das Überschreiten einer Alarmschwelle (AS), die durch eine bestimmte Phasendifferenz zwischen der Eingangs- und Ausgangsfrequenz des Phasenregelkreises definiert ist, einen Synchronalarm auslöst,
**gekennzeichnet durch** folgende Merkmale:
a) Das Überschreiten einer Gradientenschwelle, die durch eine bestimmte Änderung einer Phasendifferenz (PD) zwischen Eingangs- und Ausgangsfrequenz in einer bestimmten ersten Zeitspanne (T1) definiert ist, wird überwacht,
b) während einer von den Zeitkonstanten des Phasenregelkreises abhängigen zweiten Zeitspanne (T2), die mit dem erstmaligen Überschreiten der Gradientenschwelle beginnt, wird auch bei Überschreiten der Alarmschwelle verhindert, daß ein Synchronalarm ausgelöst wird,
c) sofern die Gradientenschwelle innerhalb der zweiten Zeitspanne wieder unterschritten wird und die Alarmschwelle vorher überschritten wurde, wird das Verhindern des Synchronalarms erst aufgehoben, wenn die Alarmschwelle wieder unterschritten wird.

2. Verfahren nach Anspruch 1,
**gekennzeichnet durch** folgende Merkmale:
a) Das Überschreiten der Gradientenschwelle wird durch das Überschreiten einer relativen Schwelle (FS), die kleiner als die Alarmschwelle ist, vor Ablauf einer ersten Zeitspanne (T1) eines ersten Zeitgliedes (TÜ1) überwacht,
b) bei jedem Überschreiten der Gradientenschwelle wird
b1) das erste Zeitglied erneut gestartet, d.h. es wird auf erneutes Überschreiten der Gradientenschwelle überwacht,
b2) eine Phasenkorrektur durchgeführt, die die Phasendifferenz am Eingang des Phasendiskriminators zu Null setzt,
b3) der bis zu der Phasenkorrektur aufgelaufene Wert der Phasendifferenz gespeichert um diesen für die weitere Stellwertberechnung mit zu berücksichtigen,
c) bei einem erstmaligen Überschreiten der Gradientenschwelle wird außerdem ein zweites Zeitglied (TÜ2) gestartet, das die genannte zweite Zeitspanne (T2) bestimmt und bei deren Ablauf ein Synchronalarm ausgelöst wird,
d) die erste Zeitspanne (T1) ist so bemessen, daß das Ausgangssignal (OUT) des Phasendiskriminators bei einem Ablauf des ersten Zeitgliedes, d.h. bei einem Unterschreiten der Gradientenschwelle auch die genannte Alarmschwelle (AS) mit Sicherheit nicht mehr überschreiten kann,
e) der Ablauf des ersten Zeitgliedes löscht das zweite Zeitglied.

3. Verfahren nach Anspruch 2,
**dadurch gekennzeichnet,**
daß der Regler ein PI-Regler ist und der vor der Phasenkorrektur aufgelaufene Wert der Phasendifferenz in dessen Integrationsregister übertragen wird.

## Claims

1. Method for monitoring the regulation ability of a phase-locked loop, preferably of a phase-locked loop in a central clock generator of a telecommunication exchange, in which the exceeding of an alarm threshold (AS), which is defined by a specific phase difference between the input and output frequency of the phase-locked loop, triggers a synchronous alarm, characterized by the following features:
a) the exceeding of a gradient threshold, which is defined by a specific change in the phase difference (PD) between input and output frequency in a specific first time period (T1), is monitored,
b) during a second time period (T2), which depends on the time constants of the phase-locked loop and begins the first time the gradient threshold is exceeded, the triggering of a synchronous alarm is prevented even if the alarm threshold is exceeded,
c) insofar as the value falls below the gradient threshold again within the second time period and the alarm threshold was previously exceeded, the prevention of the synchronous alarm is only cancelled once the value falls below the alarm threshold again.

2. Method according to Claim 1, characterized by the following features:
a) the exceeding of the gradient threshold is monitored by the exceeding of a relative threshold (FS), which is lower than the alarm threshold, before the expiry of a first time period (T1) of a first timer element (TÜ1),
b) every time the gradient threshold is exceeded
b1) the first timer element is restarted, that is to say monitoring takes place for the renewed exceeding of the gradient threshold,
b2) a phase correction is performed which sets the phase difference at the input of the phase discriminator to zero,
b3) the value of the phase difference accumulated until the phase correction is stored in order to include it in the further control output calculation,
c) when the gradient threshold is exceeded for the first time a second timer element (TÜ2) is additionally started which specifies the aforesaid second time period (T2) and which triggers a synchronous alarm when it expires,
d) the first time period (T1) is dimensioned in such a way that it is certain that the output signal (OUT) of the phase discriminator also can no longer exceed the aforesaid alarm threshold (AS) when the first timer element expires, that is to say when the value falls below the gradient threshold,
e) the expiry of the first timer element clears the second timer element.

3. Method according to Claim 2, characterized in that the controller is a PI controller, and the phase difference value accumulated before the phase correction is transferred into its integration register.

## Revendications

1. Procédé pour contrôler la capacité de régulation d'une boucle à verrouillage de phase, notamment d'une boucle à verrouillage de phase située dans un générateur central de cadence d'un central de télécommunication, selon lequel le dépassement d'un seuil d'alarme (AS), qui est défini par une différence de phase déterminée entre la fréquence d'entrée et la fréquence de sortie de la boucle à verrouillage de phase, déclenche une alarme de synchronisation,
caractérisé par les particularités suivantes :
a) on contrôle le dépassement d'un seuil de gradient, qui est défini par une variation déterminée d'une différence de phase (PD) entre des fréquences d'entrée et de sortie au cours d'un premier intervalle de temps déterminé (T1),
b) pendant un second intervalle de temps (T2), qui dépend de la constante de temps de la boucle à verrouillage et qui commence lors du premier dépassement du seuil de gradient, également lors du dépassement du seuil d'alarme, on empêche le déclenchement d'une alarme de synchronisation,
c) dans la mesure où le seuil de gradient a été à nouveau dépassé par valeurs inférieures au cours du second intervalle de temps et que le seuil d'alarme a été auparavant dépassé par valeurs supérieures, on ne supprime le blocage empêchant l'alarme de synchronisation que lorsque le seuil d'alarme est à nouveau dépassé par valeurs inférieures.

2. Procédé suivant la revendication 1, caractérisé par les particularités suivantes :
a) on contrôle le dépassement du seuil de gradient sur la base du dépassement d'un seuil relatif (FS), qui est inférieur au seuil d'alarme, avant l'écoulement d'un premier intervalle de temps (T1) d'une première minuterie (TÜ1),
b) lors de chaque dépassement du seuil de gradient par valeurs supérieures,
b1) on déclenche la première minuterie à nouveau, c'est-à-dire que l'on contrôle un nouveau dépassement du seuil de gradient par valeurs supérieures,
b2) on effectue une correction de phase, qui règle à zéro la différence de phase à l'entrée du discriminateur de phase,
b3) on mémorise la valeur, présente jusqu'à la correction de phase, de la différence de phase, afin que cette valeur soit prise en compte simultanément pour la poursuite du calcul de la valeur de réglage,
c) en outre, dans le cas du premier dépassement du seuil de gradient par valeurs supérieures, on met en marche une seconde minuterie (TÜ2), cette minuterie déterminant ledit second intervalle de temps (T2) et déclenchant une alarme de synchronisation à la fin de cet intervalle de temps,
d) le premier intervalle de temps (T1) est dimensionné de telle sorte que le signal de sortie (OUT) du discriminateur de phase ne peut également plus dépasser de façon sûre le seuil d'alarme indiqué (AS), à la fin de la durée de la première minuterie, c'est-à-dire lors d'un dépassement du seuil de gradient par valeurs inférieures,
e) I'arrêt de la première minuterie positionne à zéro la seconde minuterie.

3. Procédé suivant la revendication 2, caractérisé par le fait que le régulateur est un régulateur PI à action proportionnelle et intégrale et que l'on transfère la valeur, présente avant la correction de phase, de la différence de phase, dans le registre d'intégration de ce régulateur.
